Europäisches Patentamt

European Patent Office

Office européen des brevets

(19)

(11) Veröffentlichungsnummer: **0 123 309**
**B1**

(12) **EUROPÄISCHE PATENTSCHRIFT**

(45) Veröffentlichungstag der Patentschrift: 27.06.90

(21) Anmeldenummer: 84104577.6

(22) Anmeldetag: 24.04.84

(51) Int. Cl.⁵: **H 01 L 21/60**, H 01 L 23/48

(54) Verfahren zum Herstellen von stabilen, niederohmigen Kontakten in integrierten Halbleiterschaltungen.

(30) Priorität: 25.04.83 DE 3314879

(43) Veröffentlichungstag der Anmeldung:
31.10.84 Patentblatt 84/44

(45) Bekanntmachung des Hinweises auf die
Patenterteilung:
27.06.90 Patentblatt 90/26

(84) Benannte Vertragsstaaten:
AT CH DE FR GB IT LI

(56) Entgegenhaltungen:
EP-A-0 070 737      US-A-4 214 256
EP-A-0 119 497

IBM TECHNICAL DISCLOSURE BULLETIN, Band
24, Nr. 12, Mai 1982, Seite 6545-6547, New York,
US; D.A. SODERMAN: "Simplified
polysilicon/silicide process and structure"

IBM TECHNICAL DISCLOSURE BULLETIN, Band
20, Nr. 9, Februar 1978, Seiten 3480-3483, New
York, US; T.M. REITH et al.: "Controlled ohmic
contact and planarization for very shallow
junction structures"

(73) Patentinhaber: Siemens Aktiengesellschaft
Wittelsbacherplatz 2
D-8000 München 2 (DE)

(72) Erfinder: Widmann, Dietrich, Dr.-Ing.
Ludwig-Steub-Strasse 2
D-8025 Unterhaching (DE)
Erfinder: Sigusch, Reiner Dipl.-Ing. (FH)
Mainaustrasse 71
D-8000 München 60 (DE)

(56) References cited:
IBM TECHNICAL DISCLOSURE BULLETIN, Band
24, Nr. 12, Mai 1982, Seite 6483, New York, US;
B. HAFNER et al.: "Method of producing contact
metallizations"

IBM TECHNICAL DISCLOSURE BULLETIN, Band
19, Nr. 12, Mai 1977, Seiten 4601-4604, New
York, US; C.G. JAMBOTKAR: "Method for
reducing the emitter-base contact distance in
bipolar transistors"

EP 0 123 309 B1

**Beschreibung**

Die Patentanmeldung betrifft ein Verfahren zum Herstellen von stabilen, niederohmigen Kontakten in integrierten Halbleiterschaltungen mit einem aus Silizium bestehenden Substrat, in dem und auf dem die die Schaltung bildenden Elemente erzeugt sind und mit einer aus Aluminium oder einer Aluminiumlegierung bestehenden äußeren Kontaktleiterbahnebene, welche unter Verwendung einer Metallsilizidzwischenschicht mit den diffundierten Siliziumbereichen der Schaltung verbunden ist.

In heutigen VLSI-Schaltungen, die durch minimale Strukturen um 2 µm gekennzeichnet sind, werden die Kontakte zwischen den Aluminium-Leiterbahnen und den darunter befindlichen einkristallinen oder polykristallinen Siliziumbereichen im allgemeinen dadurch realisiert, daß in eine isolierende Schicht, zum Beispiel eine ca. 1 µm dicke $SiO_2$-Schicht Kontaktlöcher geätzt werden. Dann wird das Leitbahnmuster, meist bestehend aus Aluminium mit geringfügigen Zusätzen von Silizium und Kupfer, ausgebildet, sodaß im Kontaktloch ein direkter Kontakt zwischen dem Metall und dem dotierten Silizium entsteht.

Mit fortschreitender Verkleinerung der lateralen Strukturabmessungen wird in der Regel auch die Eindringtiefe der zu kontaktierenden dotierten Siliziumbereiche geringer. Sie beträgt bei MOS-Schaltungen mit 1 µ-Strukturen ca. 0,2 µm. Andererseits besteht die Tendenz, die Dicke der Isolationsschicht und damit die Tiefe der Kontaktlöcher nicht oder nur geringfügig zu verringern, um parasitäre Kapazitäten möglichst klein zu halten. Für MOS-Schaltungen mit Kontaktlochgrößen von 1 µm kann zum Beispiel eine Isolationsschichtdicke von 1 µm wünschenswert sein.

Bedingt durch diese Verhältnisse bei verkleinerten Schaltungen (kleine Eindringtiefe, kleine Kontaktlochfläche, tiefe Kontaktlöcher) ergeben sich bei Anwendung des aus dem Stand der Technik bekannten Aluminiumkontaktes eine Reihe von Problemen, die für das Beispiel eine n-Kanal-MOS-Schaltung im folgenden aufgelistet sind:

1. Der Schichtwiderstand der diffundierten Bereiche steigt wegen der kleineren Eindringtiefe an und verschlechtert zum Beispiel die Steilheit der MOS-Transistoren.

2. Bei überschüssigem Silizium im Aluminium kann es zu Siliziumausschiedungen in den Kontaktlöchern kommen. Diese Ausschiedungen haben einen erhöhten Kontaktwiderstand zur Folge, wenn die Abmessungen der Kontaktlöcher so klein werden, daß sie in die Größenordnung der ausgeschiedenen Siliziumkristallite kommen oder wenn die Ausscheidungen epitaktisch im ganzen Kontaktloch aufwachsen (bei nachfolgenden Wärmebehandlungen).

3. Bei zu geringem Siliziumgehalt im Aluminium kommt es zu Aluminium-Silizium-Reaktionen im Kontaktloch. Reicht die Reaktionszone auch nur lokal bis zur Eindringtiefe des diffundierten Gebietes, so wird hier der pn-Übergang kurzgeschlossen. Bei kleinen Eindringtiefen verscharft sich dieses Problem.

4. Der elektrische Strom fließt im Kontaktloch nicht mit homogener Stromdichte vom Aluminium in den diffundierten Bereich. Vielmehr kommt es am Kontaktlochrand zu einer Stromzusammendrängungn, die bei kleinerer Eindringtiefe des diffundierten Bereiches größ wird. Die lokal erhöhte Stromdichte kann zu einer Materialwanderung (Elektromigration) und starker lokaler Erwärmung im Kontaktlochbereich (Zuverlässigkeit) führen.

5. Bei Schaltungen mit Strukturen im Bereich von 1 µm müssen die Aluminium-Leitbahnen mit anisotropen Ätzverfahren geätzt werden, um die Unterätzung unter die Lackmaske möglichst gering zu halten. Die heute bekannten anisotropen Ätzvberfahren für Aluminium (Plasmaätzen, reaktives Ionenätzen, reaktives Ionenstrahlätzen) haben die Eigenschaft, daß auch Silizium geätzt wird, und zwar mit vergleichbarer Ätzrate, jedenfalls nicht einer um Größenordnungen kleineren Ätzrate. Dies hat zur Fogle, daß an solchen Stellen, wo die Aluminiumschicht über Silizium geätzt wird (zum Beispiel im Kontaktlochbereich), nach dem vollständigen Abtrag des Aluminiums das darunterliegende Silizium ebenfalls geringfügig abgetragen wird. Bei geringer Eindringtiefe des diffundiertren Bereichs kann dieser bis zum pn-Übergang durchgeätzt werden, wodurch die elektrischen Sperreigenschaften des pn-Übergangs beeinträchtigt werden. Es ist in den Schaltungen zwar üblich, daß die Aluminium-Leitbahnen die Kontaktlöcher vollständig bedecken, so daß der geschilderte Fall des Durchätzens eines diffundierten Bereiches eigentlich nicht eintreten kann, aber ein einziger sonst unbedeutender Maskenfehler oder ein etwas zu großer Justierfehler beim Justieren der Aluminiummaske kann zu dem geschilderten Effekt und eventuell zum Ausfall der gesamten Schaltung führen.

6. Da die Kontaktlöcher verkleinerter Schaltungen sehr kleine laterale Abmessungen (zum Beispiel 1 µm × 1 µm) bei relativ agroßer Tiefe (zum Beispiel 1 µm) aufweisen können, kommt es im Kontaktloch bei der Metallbeschichtung infolge von Abschattungseffekten zu einer stark verminderten Metallbelegung im Kontaktloch und an den steilen Kontaktlochflanken. Dieser Effekt vermindert die Zuverlässigkeit der Schaltungen. Das Problem ist noch gravierender, wenn eine Mehrlagenmetallisierung vorgesehen ist, da dann unter Umstanden jede der nachfolgenden Schichten (Metall- und Isolationsschicht) von dem Problem betroffen ist.

Die unter 1. und 3. geschilderten Probleme können durch eine Silizidschicht auf den diffundierten Gebieten behoben bzw. gemildert werden, wie beispielsweise aus einem Aufsatz von P. A. Gargini, I. Beinglass aus dem IEDM Digest, Seiten 54 bis 57 (Dezember 1981) zu entnehmen ist.

Um den unter den Punkten 2., 3., 4. und 6. geschilderten Problemen zu begegnen, wurde in einem Aufsatz von S. Vaidya in Appl. Phys. Letters 39 (11), Seiten 900 bis 902 (Dezember 1981) vorgeschlagen, anstelle der Aluminium-(+ ca. 1% Silizium)-Metallisierung eine Doppelschicht aus $n^+$-dotiertem Polysilizium und Aluminium zu verwenden.

Das unter Punkt 6. angeschnittene Problem der stark verminderten Metallbelegung im Kontaktloch kann auch durch Ausbildung schräger Kontaktlochflanken vermindert werden, wie beispielsweise in einem Aufsatz von R. A. Moline in IEEE Trans. Electron. Dev., ED—20, Seite 840 (1973) bekannt ist.

Aus der EP—A—0 119 497 (Art.54—3) Patentschrift ist ein Verfahren zum Herstellen von niederohmigen Kontakten in integrierte Schaltungen bekannt, in dem die diffundierten Bereiche im Kontaktlochbereich mit einer Metallsilizidschicht bedeckt werden; zusätzlich wird als äußere Kontaktleiterebene eine Legierung aus Polysilizium und Aluminium verwendet. Zu diesem Zweck wird das Kontaktloch völlig mit Polysilizium gefüllt und eine Aluminiumschicht wird gebildet. Durch eine anschließende Wärmebehandlung entsteht die Legierung.

Die Erfindung dient zur Lösung der Aufgabe, alle diese Probleme zu beheben und ein Verfahren anzugeben, mit dessen Hilfe stabile, niederohmige Kontakte auch bei VLSI-Schaltungen herstellbar sind.

Die Erfindung betrifft ein Verfahren der eingangs genannten Art, welches durch folgende Merkmale gekennzeichnet ist:

a) die für die Kontaktierung vorgesehenen diffundierten Bereiche der Schaltung werden mit Kontaktlöchernn gleicher, den minimalen Abmessungen der Schaltungselemente angepaßter Größe versehen,

b) gegebenenfalls werden bei größerflächigen diffundierten Bereichen mehrere solcher gleich großer Kontaktlöcher eingebracht,

c) die diffundierten Bereiche im Kontaktlochbereich werden mit einer Metallsilizidschicht oder mit einer Metall/Metallsilizid-Doppelschicht bedeckt und

d) als äußere Kontaktleiterbahnebene werden Doppelschichten aus $n^+$-dotiertem Polysilizium und Aluminium verwendet, wobei die Kontaktlöcher fast vollständig mit dem Polysilizium gefüllt sind, so daß eine fast ebene Oberfläche entsteht.

Weitere Ausgestaltungen der Erfindung ergeben sich aus den Unteransprüchen.

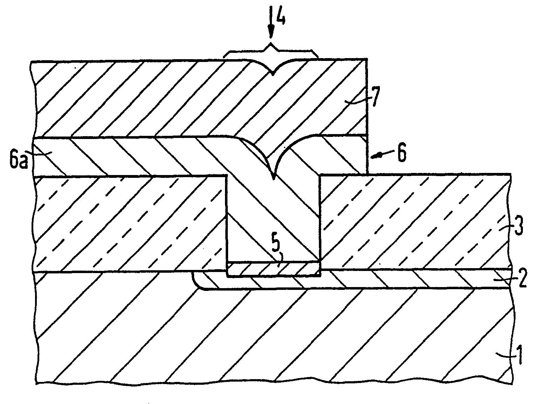

Im folgenden wird anhand der in der Zeichnung befindlichen Figur der Schichtaufbau des Kontaktes in einem Kontaktloch im Schnittbild noch näher erläutert. Dabei ist mit dem Bezugszeichen 1 das den $n^+$- bzw. $p^+$-dotierten Bereich 2 enthaltende Siliziumsubstrat und mit 3 die das Kontaktloch (siehe Pfeil 4) von der Größe 1 $\mu$m × 1 $\mu$m enthaltende $SiO_2$-Schicht bezeichnet. Auf den Kontaktlochbereich (4) des $n^+$ bzw. $p^+$-dotierten Bereiches 2 wird nach bekannten Verfahren eine Silizidschicht, zum Beispiel eine Platinsilizidschicht 5 in einer Schichtdicke von 50 bis 100 nm niedergeschlagen und darauf mittels eine Niederduckgasphasenabscheidung $^+$dotiertes Polysilizium 6 aufgebracht. Wichtig ist, daß das Kontaktloch 4 fast vollständig mit Polysilizium 6 gefüllt ist, so daß eine fast ebene Oberfläche entsteht. Die Dicke der Polysiliziumschicht 6a wird über der $SiO_2$-Schicht 3 auf etwa die halbe Kontaktlochkantenlänge eingestellt, das sind im Ausführungsbeispiel etwa 0,4 bis 0,5 $\mu$m. Abschließend wird eine Aluminium-Schicht 7 in einer Schichtdicke von ca. 1 $\mu$m aufgedampft. Nach Aufbringen einer Fotolackmaske wird das Leiterbahnmuster durch Ätzen der Doppelschicht (1 $\mu$m Al, 0,4 bis 0,5 $\mu$m Polysilizium) definiert.

Die eingangs aufgefußhrten Probleme 1 bis 6 werden durchh die Erfindung wie folgt behoben:

*Problem 1:* Durch die Metallsilizidschicht 5.

*Problem 2:* Durch die Polysiliziumschicht 6 unter der Aluminiumschicht 7.

*Problem 3:* Durch die Metallsilizidschicht 5 und durch die Polysiliziumschicht 6 unter der Aluminiumschicht 7.

*Problem 4:* Oberhalb und unterhalb der Polysiliziumschicht 6 befinden sich im Kontaktlochbereich (4) Schichten, die eine wesentlich höhere Leitfähigkeit haben als das $n^+$-dotierte Polysilizium 6. Aus energetischen Gründen ergibt sich in diesem Fall eine nahezu homogene Stromdichte-Verteilung im Kontaktloch 4. Für das oben angenommene Beispiel eines 1 $\mu$m tiefen Kontaktlochs mit 1 $\mu$m$^2$ Fläche beträgt der Widerstand für den vertikalen Stromfluß im Kontaktloch ca. 10 Ohm bei einem angenommenen spezifischen Widerstand des Polysiliziums von $10^{-3}$ Ohm cm.

*Problem 5:* Bei der Ätzung der Polysilizium-Aluminium-Doppelschicht 6, 7 ist auch bei einer nicht vollständigen Bedeckung des Kontaktlochs 4 durch die Ätzmaske nicht mit einem Durchätzen bis zur Silizidschicht 5 zu rechnen, weil das Polysilizium 6 im Kontaktloch 4 wesentlich dicker ist als die durchzuätzende Polysiliziumschicht 6a. Bei einem lokalen Maskenfehler oder einer größeren Masken-Fehljustierung sind keine katastrophalen Folgen zu erwarten, selbst wenn diese Fehler nahezu die Größe der Kontaktlochabmessung aufweisen. Lediglich der Kontaktlochwiderstand wird etwas höher.

*Problem 6:* Dieses Problem wird behoben durch die nahezu planare Oberfläche im Kontaktlochbereich 4.

Das erfinddungsgemäße Verfahren ist nicht nur für n-Kanal-MOS-Schaltungen, die hier meist beispielhaft erwähnt wurden, sondern im Prinzip auch für CMOS- und Bipolarschaltungen geeignet, bei denen sowohl n- als auch p-dotierte Gebiete kontaktiert werden müssen.

Besteht die Isolationsschicht (im Ausführungsbeispiel $SiO_2$) aus einem Material, das eine geringere Temperaturstabilität aufweist, zum Beispiel aus Polyamid, das eine maximale Temperatur von ca. 400°C verträgt, so ist das Verfahren auch anwendbar, wenn sowohl die Polysiliziumbeschichtung (6) als auch die Aktivierung des Dotierstoffes im Polysilizium (Phosphor oder Arsen) bei Temperaturen unter 400°C erfolgen, bzw. die Isolationsschicht nicht beeinträchtigen. Zum Beispiel kann dies durch eine Plasmaabscheidung des Polysiliziums und eine Laserstrahl- oder Elektronenstrahl-Aktivierung des Dotierstoffes realisiert werden.

Das Verfahren ist auch anwendbar für Kontaktlöcher bei einer Mehrlagenmetallisierung, bei der Kontakte zwischen Aluminiumleitbahnen aus einer ersten und einer zweiten Metallisierungsebene realisiert werden müssen.

In einer weiteren Ausführungsform der Erfindung ist vorgesehen, das bekannte Verfahren zur Einebnung von Schichten wie in einem Aufsatz von Adams und Capio im J. Electrochem. Soc. 128, No. 2 (1981) auf den Seiten 423 bis 429 beschrieben, auf die Polysiliziumschicht (6) anzuwenden (vor der Aluminiumbeschichtung (7)). Das Polysilizium wird bei diesem Vorgehen ganzflächig in einer Dicke abgetragen, die etwas größer ist als die auf ebenen Teilen der Oberfläche abgeschiedene Polysiliziumschicht. Nach dem Schichtabtrag verbleibt dann das Polysilizium (6) nur in den Kontaktlöchern (4), die fast vollständig mit Polysilizium gefußllt sind. Dadurch liegt auf den $SiO_2$-Bereichen keine Doppelschicht mehr vor, was für spezielle Ätzprobleme von Bedeutung ist.

**Patentansprüche**

1. Verfahren zum Herstellen von stabilen, niederohmigen Kontakten in integrierten Halbleiterschaltungen mit einem aus Sililzium bestehenden Substrat (1), in dem und auf dem die die Schaltung bildenden Elemente (2) erzeugt sind und mit einer aus Aluminium oder aus einer Aluminium-Legierung bestehenden äußeren Kontaktlieterbahnebene (7), welche unter Verwendung einer Metallsilizidzwischenschicht (5) mit den diffundierten Siliziumbereichen (2) der Schaltung verbunden ist, dadurch gekennzeichnet, daß

a) die für die Kontaktierung vorgesehenen diffundierten Bereiche (2) der Schaltung mit Kontaktlöchern (4) gleicher, den minimalen Abmessungen der Schaltungselemente angepaßter Größe versehen werden,

b) gegebenenfalls bei größerflächigen diffundierten Bereichen (2) mehrere solcher gleichgroßer Kontaktlöcher (4) eingebracht werden,

c) die diffundierten Bereiche (2) im Kontaktlochbereich (4) mit einer Metallsilizidschicht (5) oder mit einer Metall/Metallsilizid-Doppelschicht (5) bedeckt bedeckt werden und

d) als äußere Kontaktleiterbahnebene Doppelschichten aus $n^+$-dotierten Polysilizium (6) und Aluminium (7) verwendet werden, wobei die Kontaktlöcher (4) fast vollständig mit dem dotierten Polysilizium (6) gefüllt sind, so daß eine fast ebene Oberfläche entsteht.

2. Verfahren nach Anspruch 1, dadurch gekennzeichnet, daß die Dicke der $n^+$-dotierten Polysiliziumschicht (6a) über dem Kontaktloch (4) so eingestellt wird, daß sie etwa der halben Kontaktlochkantenlänge entspricht.

3. Verfahren nach Anspruch 1 und/oder 2, dadurch gekennzeichnet, daß als Mettallsilizid (5) Platin-Silizid verwendet wird.

4. Verfahren nach Anspruch 1 bis 3, dadurch gekennzeichnet, daß zwischen der Metallsilizidschicht (5) und dem $n^+$-dotierten Polysilizium (6) eine aus Chrom-Chromoxid ($CrCr_xO_y$)-bestehende Barriereschicht in einer Schichtdicke im Bereich von 150 nm erzeugt wird.

5. Verfahren nach einem der Ansprüche 1 bis 3, dadurch gekennzeichnet, daß die Aluminiumschicht (7) einen Anteil von 1 bis 2% Silizium enthält.

6. Verfahren nach Anspruch 5, dadurch gekennzeichnet, daß der Aluminiumschicht (7) bis zu 6% Kupfer zugesetzt werden.

7. Verfahren nach Anspruch 1 bis 6, dadurch gekennzeichnet, daß die Abscheidung des $n^+$-dotierten Polysiliziums (6) so geführt wird, daß die Abscheiderate auf horizontalen und vertikalen Teilen des Substrats (1, 2, 3, 5) gleich hoch ist.

8. Verfahren nach Anspruch 7, dadurch gekennzeichnet, daß · das $n^+$-dotierte Polysilizium (6) durch eine Niederdruck-Gasphasenabscheidung, durch eine plasma-induzierte Gasphasenabscheidung oder durch eine fotochemisch-induzierte Gasphasenabscheidung niedergeschlagen wird.

9. Verfahren nach Anspruch 1 bis 8, dadurch gekennzeichnet, daß vor der Abscheidung der Aluminiumschicht (7) die $n^+$-dotierte Polysiliziumschicht (6) ganzflächig so weit abgetragen wird, · daß nur das Kontaktloch (4) mit Polysilizium (6) gefüllt bleibt.

10. Verfahren des Verfahrens nach Anspruch 1 bis 9 zur Herstellung von MOS- und Bipolar-Schaltungen in VLSI-Technologie.

**Revendications**

1. Procédé pour fabriquer des contacts stables, de faible valeur ohmique, dans des circuits intégrés à semiconducteurs comportant un substrat (1) formé de silicium, dans et sur lequel sont formés les éléments (2) constituant le circuit, et un plan extérieur (7) des voies conductrices de contact, réalisé en aluminium ou en un alliage d'aluminium et relié aux zones diffusées de silicium (2) du circuit, moyennant l'utilisation d'une couche intermédiaire de siliciure métallique (5), caractérisé par le fait que

a) les régions diffusées (2) du circuit, qui sont prévues pour l'établisseement des contacts, comportent des trous de contact (4) possédant une même taille, adaptée aux dimensions minimales des éléments de circuit,

b) éventuellement dans le cas de régions diffusées (2) possédant une surface plus étendue, on forme plusieurs trous de contact (4) de même taille de ce type,

(c) on recouvre les régions diffusées (2), dans la région (4) des trous de contact, par une couche de siliciure métallique (5) ou par une couche double de métal-siliciure métallique (5), et

(d) comme plan extérieur des voies conductrices de contact, on utilise des couches doubles formées de polysilicium (6) dopé du type $n^+$ et d'aluminium (7), les trous de contact (4) étant presque complètement remplis par le polysilicium dopé (6) de sorte que l'on obtient une surface presque plane.

2. Procédé suivant la revendication 1, caractérisé par le fait qu'on règle l'épaisseur de la couche de polysilicium (6a) dopée du type $n^+$ au-dessus du trou de contact (4) de manière qu'elle corresponde approximativement à la moitié de la longueur du bord des trous de contact.

3. Procédé selon la revendication 1 et/ou 2, caractérisé par le fait qu'on utilise du siliciure de platine comme siliciure métallique (5).

4. Procédé suivant les revendications 1 à 3, caractérisé par le fait qu'entre la couche de siliciure métallique (5) et le polysilicium (6) dopé du type $n^+$, on forme une couche formant barrière, formée de chrome — oxyde de chrome ($CrCr_xO_y$), avec une épaisseur de l'ordre de 150 nm.

5. Procédé suivant l'une des revendications 1 à 3, caractérisé par le fait que la couche d'aluminium (7) contient un pourcentage de 1 à 2% de silicium.

6. Procédé suivant la revendication 5, caractérisé par le fait qu'on ajoute jusqu'à 6% de cuivre à la couche d'aluminium (7).

7. Procédé suivant l'une des revendications 1 à 6, caractérisé par le fait qu'on effectue le dépôt du polysilicium (6) dopé du type $n^+$ de manière que la vitesse de dépôt soit identique sur des surfaces horizontale et verticale du substrat (1, 2, 3, 5).

8. Procédé suivant la revendication 7, caractérisé par le fait qu'on dépose le polysilicium dopé du type $n^+$ au moyen d'un dépôt en phase gazeuse à basse pression, d'un dépôt en phase gazeuse déclenché par un plasma, ou d'un dépôt en phase gazeuse déclenché par voie photochimique.

9. Procédé suivant les revendications 1 à 8, caractérisé par le fait qu'avant le dépôt de la couche d'aluminium (7), on élimine, sur toute sa surface, la couche (6) de polysilicium dopée du type $n^+$ de manière que seul le trou de contact (4) reste rempli de polysilicium (6).

10. Mise en oeuvre du procédé suivant l'une des revendications 1 à 9 pour fabriquer des circuits MOS et des circuits bipolaires selon la technologie VLSI.

**Claims**

1. Method of manufacturing stable, low resistance contacts in integrated semiconductor circuits having a substrate (1) made of silicon, in which and on which the elements (2) forming the circuit are produced, and having an outer interconnection layer (7) which is made of aluminium or of an aluminium alloy and is connected to the diffused silicon regions (2) of the circuit with the employment of an intermediate layer of metal silicide (5), characterized in that

a) the diffused regions (2) of the circuit which are provided for the contacting are provided with contact holes (4) of uniform size matched to the minimum dimensions of the circuit elements,

b) a plurality of such uniform contact holes (4) are provided for larger-area diffused regions (2) if desired,

c) the diffused regions (2) in the contact hole region (4) are covered with a metal silicide layer (5) or with a metal/metal silicide double layer (5), and

d) double layers consisting of $n^+$-doped polysilicon (6) and aluminium (7) are employed as outer interconnection layers, the contact holes (4) being nearly completely filled with the doped polysilicon (6) so that a nearly planar surface results.

2. Method according to Claim 1, characterized in that the thickness of the $n^+$-doped polysilicon layer (6a) above the contact hole (4) is set in such a way that it corresponds to approximately half the length of the contact hole side.

3. Method according to Claim 1 and/or 2, characterized in that platinum silicide is employed as metal silicide (5).

4. Method according to Claim 1 to 3, characterized in that a barrier layer consisting of chromium-chromic oxide ($CrCr_xO_y$) is produced with a layer thickness in the range of 150 nm between the metal silicide layer (5) and the $n^+$-doped polysilicon (6).

5. Method according to one of Claims 1 to 3, characterized in that the aluminium layer (7) contains a proportion of 1 to 2% silicon.

6. Method according to Claim 5, characterized in that up to 6% copper is added to the aluminium layer (7).

7. Method according to Claim 1 to 6, characterized in that the $n^+$-doped polysilicon (6) is deposited at the same rate on horizontal and vertical portions of the substrate (1, 2, 3, 4, 5).

8. Method according to Claim 7, characterized in that the $n^+$-doped polysilicon (6) is deposited by means of a low pressure vapour phase deposition, by means of a plasma-induced vapour phase deposition or by means of a photochemically induced vapour phase deposition.

9. Method according to Claim 1 to 8, characterized in that, before the deposition of the aluminium layer (7), the $n^+$-doped polysilicon layer (6) is removed over the entire surface to such an extent that only the contact hole (4) remains filled with polysilicon (6).

10. Application of the method according to Claim 1 to 9 for manufacturing MOS and bipolar circuits in VLSI technology.